# EUROPEAN PATENT APPLICATION

(11) **EP 2 405 415 A1**
(43) Date of publication of application: **11.01.2012**
(21) Application number: 09840978.2
(22) Date of filing: 02.03.2009
(51) Int. Cl.: G08C 23/04, H03K 17/00

(54) **DEVICE USED FOR ELIMINATING STANDBY POWER CONSUMPTION OF THE INFRARED REMOTE CONTROL ELECTRICAL APPLIANCE**

(71) Applicant: Huo, Weimin, Shenzhen, Guangdong 518038 (CN)
(72) Inventor: SUI, Haiyan, Guangdong 518038 (CN)
(74) Representative: Plucker, Guy
(86) International application number: PCT/CN2009/070595
(87) International publication number: WO 2010/099644

(57) **Abstract**

A device for eliminating standby power consumption of an electronic appliance having infrared remote control switch capability is provided, which includes: a control unit; an infrared remote control signal receiving unit connected thereto; an infrared remote control signal transmitting unit, connected to the control unit; a controlled electronic appliance power supply switch unit, connected to the control unit, a power supply unit, an external power source and a power input end of a controlled electronic appliance; and the power supply unit of the device, connected to the control unit, the controlled electronic appliance power supply switch unit, and the external power source. For the device for eliminating standby power consumption of an electronic appliance having infrared remote control switch capability, during initial installation and setting, an infrared remote power-on/off signal of the controlled electronic appliance and a preheating time after the power source of the controlled electronic appliance is turned on are received, detected and stored. In subsequent use, the power supply of the controlled electronic appliance is turned off upon receiving the infrared remote control power-off signal, the power supply of the controlled electronic appliance is turned on upon receiving the infrared remote control power-on signal, and after the controlled electronic appliance finishes preheating, an infrared remote control power-on signal is transmitted to the controlled electronic appliance to turn on the controlled electronic appliance. Therefore, without changing normal remote power-on/off operations of the user, standby power consumption of the electronic appliance having infrared remote control switch capability is eliminated.

## Description

### BACKGROUND OF THE INVENTION

### Field of Invention

The present invention relates to an electronic appliance having infrared remote control switch capability, and more particularly to a device for eliminating standby power consumption of an electronic appliance having infrared remote control switch capability.

### Related Art

After an electronic appliance having infrared remote control switch capability is powered off through remote control, to ensure that the electronic appliance can be power-on next time through infrared remote control, the electronic appliance still needs to keep supplying power to an infrared remote control signal receiving portion and a control portion thereof, so the power supply cannot be completely turned off. This part of power consumption is standby power consumption of this type of electronic appliances. A device for eliminating standby power consumption of the electronic appliance can save energy resources and protect the environment. In an existing device for eliminating standby power consumption of the electronic appliance, a power source input current of the electronic appliance is monitored. When the power source input current decreases below a preset current value, it is regarded that the electronic appliance is already powered off and power supply to the electronic appliance is turned off, so as to eliminate standby power consumption. In a status that the power supply of the electronic appliance is turned off, when any infrared signal is received, it is regarded that a user intends to turn on the electronic appliance, so the power supply to the electronic appliance is turned on. The user then needs to wait the electronic appliance to finish preheating and again turn on the electronic appliance through remote control. If the electronic appliance is still not power-on after a preset time is waited, the power supply is turned off again. The defect lies in that different electronic appliances have different standby power consumption and work power consumption, at a preset standby power consumption threshold value, the standby electronic appliance or normally working electronic appliance might be unable to be turned off. The power supply is turned on upon receiving any infrared signal, so the electronic appliance is easily power-on by mistake, thereby increasing the power consumption. When switching on the electronic appliance, the user first has to press any button on an infrared remote control to transmit an infrared remote control signal to turn on power supply of the device to the electronic appliance. Subsequently, the user needs to wait the electronic appliance to finish preheating and press a power-on button of the infrared remote control to transmit an infrared remote control power-on signal to turn on the electronic appliance, so the operation is complicated and use is convenient.

### SUMMARY OF THE INVENTION

The present invention provides device for eliminating standby power consumption of an electronic appliance having infrared remote control switch capability to solve the above problems. The device can receive and judge an infrared remote control power-on and power-off signal of a controlled electronic appliance, turn off power supply to the electronic appliance upon receiving the power-off signal to eliminate standby power consumption, turn on power supply to the electronic appliance upon receiving the power-on signal, and waits the electronic appliance to finish preheating to transmit an infrared power-on signal to the electronic appliance to turn on the electronic appliance.

To achieve the above objectives, the present invention provides a device for eliminating standby power consumption of an electronic appliance having infrared remote control switch capability, which includes:
a control unit 10;
an infrared remote control signal receiving unit 20, connected to the control unit 10; and
an infrared remote control signal transmitting unit 30, connected to the control unit 10; and
a controlled electronic appliance power supply switch unit 40, connected to the control unit 10, a power supply unit 50, and a power input end of a controlled electronic appliance 71; and
the power supply unit 50 of the device, connected to the control unit 10 and the controlled electronic appliance power supply switch unit 40.

In the device for eliminating standby power consumption of an electronic appliance having infrared remote control switch capability, the control unit 10 includes a control chip 11, a memory 12, a controlled electronic appliance power consumption current sensor 13, a setting and manual switch button 14 and a setting and work status indicator lamp 15. The memory 12, the controlled electronic appliance power consumption current sensor 13, the setting and manual switch button 14 and the setting and work status indicator lamp 15 are all connected to the control chip 11. The controlled electronic appliance power consumption current sensor 13 is further connected to the controlled electronic appliance power supply switch unit 40. The memory 12 is used for storing an infrared remote power-on/off signal of the controlled electronic appliance. A preheating time after power source to the controlled electronic appliance is turned on and a type of the controlled electronic appliance being in a standby or power-on status upon turning on the power source are written and used by the control chip 11 and can be saved for a long time after power cutoff.

In the device for eliminating standby power consumption of an electronic appliance having infrared remote control switch capability, the infrared remote control signal receiving unit 20 includes an infrared signal receiving diode 21 and an infrared signal amplification circuit 22. The infrared signal receiving diode 21 is connected to the infrared signal amplification circuit 22. The infrared signal amplification circuit 22 is connected to the control chip 11 of the control unit 10.

In the device for eliminating standby power consumption of an electronic appliance having infrared remote control switch capability, the infrared remote control signal transmitting unit 30 includes one or more infrared transmitter diodes 31. The infrared transmitter diode 31 is connected to the control chip 11. The infrared signal receiving diode 21 is a pure infrared signal receiver component, which does not perform amplification, filtering and detection processing on the received infrared signal. The infrared signal amplification circuit 22 only amplifies the infrared signal and does not perform filtering and detection processing on the infrared signal. The signal transferred to the control chip 11 contains a carrier.

In the device for eliminating standby power consumption of an electronic appliance having infrared remote control switch capability, the controlled electronic appliance power supply switch unit 40 includes a controlled electronic appliance power supply switch 41 and a power socket for supplying power to a controlled electronic appliance 42. The controlled electronic appliance power supply switch unit 40 is connected to the control unit 10 and the power supply unit 50, and is connected to the power input end 73 of the controlled electronic appliance 71 through the power socket for supplying power to a controlled electronic appliance 42 connected thereto.

In the device for eliminating standby power consumption of an electronic appliance having infrared remote control switch capability, the power supply unit 50 performs voltage drop, rectification, filtering and voltage stabilization processing on the external power source to provide direct current power supply to all units of the device. The power supply unit 50 includes a direct current power supply circuit 51 and a power plug 52 connected to the external power source 72. The power supply unit 50 is connected to the control unit 10 and the controlled electronic appliance power supply switch unit 40, and is connected to the external power source through the power plug 52 connected thereto.

In the device for eliminating standby power consumption of an electronic appliance having infrared remote control switch capability, the power supply unit (50) is connected to the external power source 72 in coordination.

In the device for eliminating standby power consumption of an electronic appliance having infrared remote control switch capability, the controlled electronic appliance power consumption current sensor 13 used for detecting a power consumption current of the controlled electronic appliance may be a alternating current mutual inductor 13A or a resistor 13B serially connected in a power supply circuit of the controlled electronic appliance.

In the device for eliminating standby power consumption of an electronic appliance having infrared remote control switch capability, when a number of infrared transmitter diodes 31 exist, the infrared transmitter diodes 31 are arranged at an angle with each other.

In the device for eliminating standby power consumption of an electronic appliance having infrared remote control switch capability, the controlled electronic appliance power supply switch 41 may be a relay switch circuit 411 or a silicon controlled switch circuit 412 controlled by the control unit 10.

The contribution of the present invention lies in that the present invention overcomes defects as follows in a conventional device for eliminating standby power consumption of an electronic appliance having infrared remote control switch capability: the standby electronic appliance or normally working electronic appliance might be unable to be turned off, the electronic appliance might be power-on by mistake causing power consumption, and for the user the operation is complicated and use is convenient. During initial installation and setting, an infrared remote power-on/off signal of the controlled electronic appliance and a preheating time after the power source of the controlled electronic appliance is turned on are received, detected and stored. In subsequent use, the power supply of the controlled electronic appliance is turned off upon receiving the infrared remote control power-off signal, the power supply of the controlled electronic appliance is turned on upon receiving the infrared remote control power-on signal, and after the controlled electronic appliance finishes preheating, an infrared remote control power-on signal is transmitted to the controlled electronic appliance to turn on the controlled electronic appliance. Therefore, without changing normal remote power-on/off operations of the user, standby power consumption of the electronic appliance having infrared remote control switch capability is eliminated.

### BRIEF DESCRIPTION OF THE DRAWINGS

The present invention will become more fully understood from the detailed description given herein below for illustration only, and thus are not limitative of the present invention, and wherein:
FIG. 1 is a principle schematic block diagram according to the present invention;
FIG. 2 is a principle schematic block diagram of a control unit, a controlled electronic appliance power supply switch unit and a power supply unit according to the present invention;
FIG. 3 is a principle schematic block diagram of an infrared remote control signal receiving unit according to the present invention;

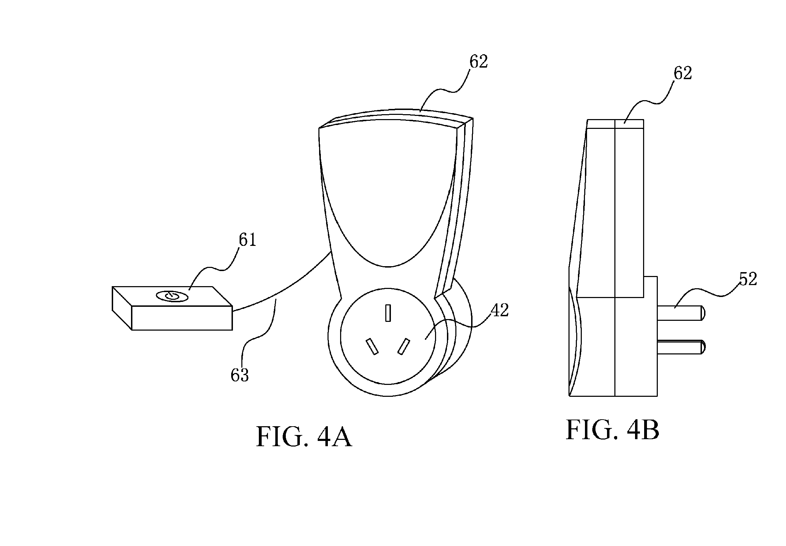

FIG. 4A is a 3D schematic structural view according to the present invention;
FIG. 4B is a 3D schematic structural side view according to the present invention;
FIG. 5 is a 3D schematic view of use according to the present invention;
FIG. 6A is a schematic view of a number of infrared remote control signal transmitter diodes being arranged at an angle according to the present invention;
FIG. 6B is a schematic view of the arrangement manner in FIG. 6A enabling the infrared signal to effectively cover all portions at the surface of the controlled device.
FIG. 7A is a principle diagram of a typical circuit when a controlled electronic appliance power supply switch unit is a relay switch circuit according to the present invention;
FIG. 7B is a principle diagram of a typical circuit when the controlled electronic appliance power supply switch unit is a silicon controlled switch circuit according to the present invention;
FIG. 8A is a principle diagram of a typical circuit of a manner when a controlled electronic appliance power consumption current sensor of the control unit is an alternating current mutual inductor according to the present invention; and
FIG. 8B is a principle diagram of a typical circuit of a manner when a controlled electronic appliance power consumption current sensor of a control unit is a resistor serially connected in a controlled electronic appliance power supply circuit according to the present invention.

### DETAILED DESCRIPTION OF THE INVENTION

The device for eliminating standby power consumption of an electronic appliance having infrared remote control switch capability of the present invention is used for eliminating standby power consumption of an electronic appliance capable of being powered on and off through remote control by using an infrared remote control such as a television and a DVD player. After an electronic appliance having infrared remote control switch capability is powered off through remote control, to ensure that the electronic appliance can be power-on next time through infrared remote control, the electronic appliance still needs to keep supplying power to an infrared remote control signal receiving portion and a control portion thereof, so the power supply cannot be completely turned off. This part of power consumption is standby power consumption of the electronic appliance.

The device control portion 61 includes a control unit 10 (not including a controlled electronic appliance power consumption current sensor 13), an infrared remote control signal receiving unit 20 and an infrared remote control signal transmitting unit 30. A power source switch portion 62 in the device includes a controlled electronic appliance power supply switch unit 40, a power supply unit 50 of the device and the controlled electronic appliance power consumption current sensor 13 of the control unit 10. In the device, the control portion 61 and the power source switch portion 62 are connected through a connecting line 63.

The use of the device includes two processes: initial installation and normal use.

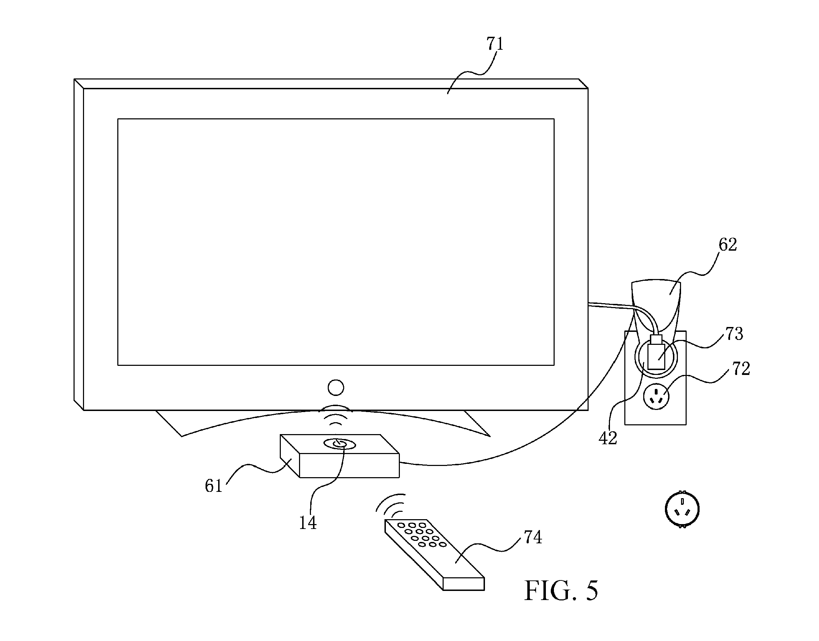

During the initial installation, as shown in FIG. 5, the control portion 61 of the device is placed in front of the controlled electronic appliance 71, a power plug of the power source switch portion 62 of the device is plugged in an external power source socket 72 and an power input end (power plug) 73 of the controlled electronic appliance 71 is plugged in a power socket for supplying power to a controlled electronic appliance 42 of the device. After installation is finished as discussed above, the setting and manual switch button 14 is pressed and held for several seconds till a setting and work status indicator lamp 15 is red indicating that the device enters a setting status and the controlled electronic appliance power supply switch unit 40 turns on power supply to the controlled electronic appliance. At this time, the controlled electronic appliance may be in two statuses: a power-on status or a standby status.

When the controlled electronic appliance is in the power-on status, the electronic appliance is powered off through remote control by using a remote control 74. The infrared remote control signal receiving unit 20 transfers the received infrared remote control signal to a control chip 11 of the control unit 10. The controlled electronic appliance power consumption current sensor 13 transfers a power consumption current value of the controlled electronic appliance to the control chip 11. The control chip 11 determines that the current received infrared signal is a power-off signal according to a decrease change of the power consumption current value of the controlled electronic appliance, and the received infrared signal is saved in the memory 12 as the infrared power-off signal for storage. The electronic appliance is powered on through remote control by using the remote control 74 again. The infrared remote control signal receiving unit 20 transfers the received infrared remote control signal to the control chip 11 of the control unit 10. The controlled electronic appliance power consumption current sensor 13 transfers the power consumption current value of the controlled electronic appliance to the control chip 11. The control chip 11 determines that the current received infrared signal is a power-on signal according to a rise change of the power consumption current value of the controlled electronic appliance, and saves the infrared signal in the memory 12 as the infrared power-on signal for storage. Meanwhile, a type of the controlled electronic appliance being in a power-on status upon turning on power source is stored in the memory 12. The setting and work status indicator lamp 15 is turned off from red. At this time, the initial installation of the controlled electronic appliance being in a power-on status upon turning on the power source is finished. The infrared signal receiving diode 21 is a pure infrared signal receiver component and does not perform amplification, filtering and detection processing on the received infrared signal. The infrared signal amplification circuit 22 only performs amplification on the infrared signal and does not perform filtering and detection processing on the infrared signal. The signal transferred to the control chip 11 contains a carrier.

When the controlled electronic appliance is in a standby status, the electronic appliance is powered on through remote control by using a remote control 74. The infrared remote control signal receiving unit 20 transfers the received infrared remote control signal to the control chip 11 of the control unit 10. The controlled electronic appliance power consumption current sensor 13 transfers the power consumption current value of the controlled electronic appliance to the control chip 11. The control chip 11 determines that the current received infrared signal is a power-on signal according to a rise change of the power consumption current value of the controlled electronic appliance, and saves the infrared signal in the memory 12 as the infrared power-on signal for storage. The electronic appliance is powered off through remote control by using the remote control 74 again. The infrared remote control signal receiving unit 20 transfers the received infrared remote control signal to the control chip 11 of the control unit 10. The controlled electronic appliance power consumption current sensor 13 transfers the power consumption current value of the controlled electronic appliance to the control chip 11. The control chip 11 determines that the current received infrared signal is a power-off signal according to a decrease change of the power consumption current value of the controlled electronic appliance, and saves the infrared signal in the memory 12 as the infrared power-off signal for storage. After the operation is finished, the control chip 11 of the control unit 10 controls the controlled electronic appliance power supply switch unit 40 to turn off power supply to the controlled electronic appliance 71. After a few minutes, the power supply to the controlled electronic appliance 71 is turned on. Meanwhile, the infrared remote control signal transmitting unit 30 is controlled to continuously transmit the infrared power-on signal to the controlled electronic appliance 71 until the power consumption current value of the controlled electronic appliance transferred by the controlled electronic appliance power consumption current sensor 13 to the control chip 11 stops rising. A continuous transmission time of the infrared power-on signal is saved in the memory 12 as the preheating time of the controlled electronic appliance for storage. Meanwhile, a type of the controlled electronic appliance being in a standby status upon turning on the power source is stored in the memory 12. The setting and work status indicator lamp 15 becomes off from red. At this time, the initial installation of the controlled electronic appliance in a standby status upon turning on the power source is finished.

During normal use, when the controlled electronic appliance is in a power-on status, the remote control 74 is used to transmit an infrared remote control signal. The infrared remote control signal receiving unit 20 transfers the received infrared remote control signal to the control chip 11 of the control unit 10. The control chip 11 compares the received infrared remote control signal with the infrared remote control power-off signal stored in the memory 12. If the received infrared remote control signal is not the infrared remote control power-off signal, no operation is performed. If the received infrared remote control signal is the infrared remote control power-off signal, the controlled electronic appliance power supply switch unit 40 is controlled to turn off the power supply to the controlled electronic appliance 71. When the controlled electronic appliance is in a power-off status, the remote control 74 is used to transmit an infrared remote control signal. The infrared remote control signal receiving unit 20 transfers the received infrared remote control signal to the control chip 11 of the control unit 10. The control chip 11 compares the received infrared remote control signal with the infrared remote control power-on signal stored in the memory 12. If the received infrared remote control signal is not the infrared remote control power-on signal, no operation is performed. If the received infrared remote control signal is the infrared remote control power-on signal, the controlled electronic appliance power supply switch unit 40 is controlled to turn on the power supply of the controlled electronic appliance 71. If the controlled electronic appliance is the type of being in a power-on status upon turning on the power source, no further operation is performed. If the controlled electronic appliance is the type of being in a standby status upon turning on the power source, a preheating time stored in the memory 12 is waited. The setting and work status indicator lamp 15 become blue indicating a preheating status. Next, the control chip 11 controls the infrared remote control signal transmitting unit 30 to transmit an infrared power-on signal to the controlled electronic appliance 71 to turn on the controlled electronic appliance and the setting and work status indicator lamp 15 becomes off from blue.

During normal use, the setting and manual switch button 14 is pressed. In a power-on status the control chip 11 controls the controlled electronic appliance power supply switch unit 40 to turn off the power supply to the controlled electronic appliance 71 to power off the controlled electronic appliance 71. In a power-off status, the control chip 11 controls the controlled electronic appliance power supply switch unit 40 to turn on the power supply of the controlled electronic appliance 71. If the controlled electronic appliance is a type of being in a power-on status upon turning on the power source, no further operation is performed. If the controlled electronic appliance is a type of being in a standby status upon turning on the power source, a preheating time stored in the memory 12 is waited. The setting and work status indicator lamp 15 becomes blue indicating a preheating status. Next, the control chip 11 controls the infrared remote control signal transmitting unit 30 to transmit an infrared power-on signal to the controlled electronic appliance 71 to turn on the controlled electronic appliance and the setting and work status indicator lamp 15 becomes off from blue. Therefore, manual switch is realized.

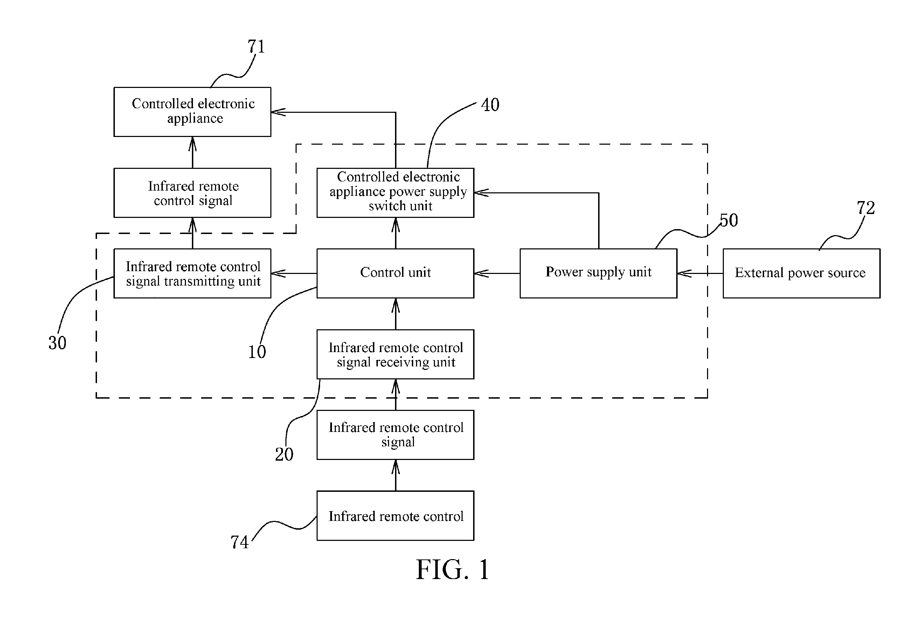

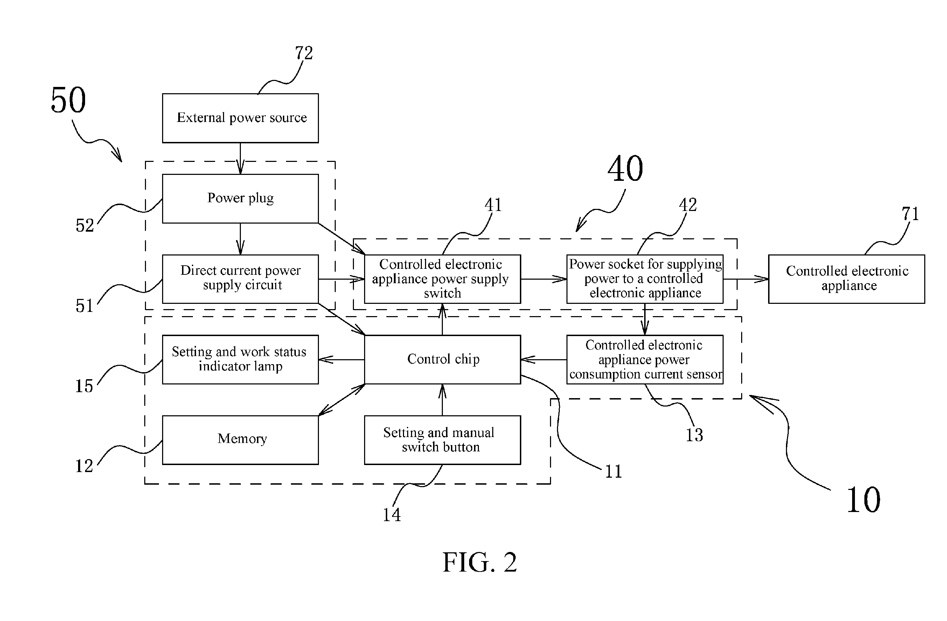

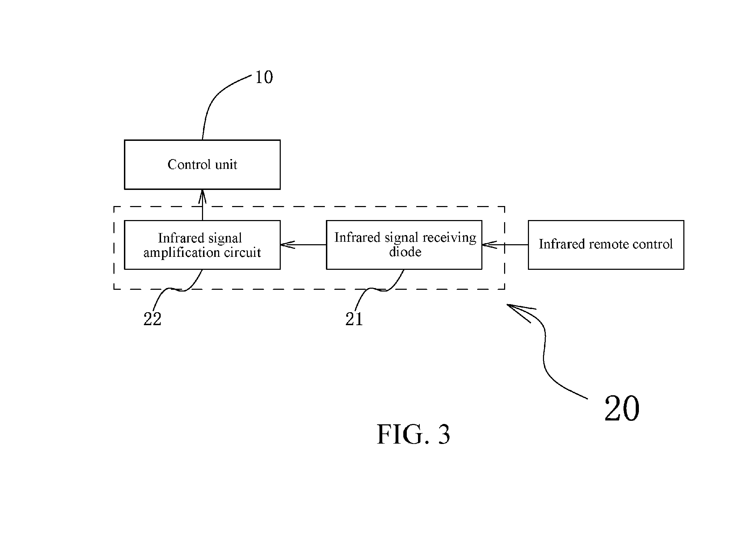

As shown in FIG. 1 to FIG. 3, the device for eliminating standby power consumption of an electronic appliance having infrared remote control switch capability according to the present invention includes a control unit 10, an infrared remote control signal receiving unit 20, an infrared remote control signal transmitting unit 30, a controlled electronic appliance power supply switch unit 40 and a power supply unit 50 of the device.

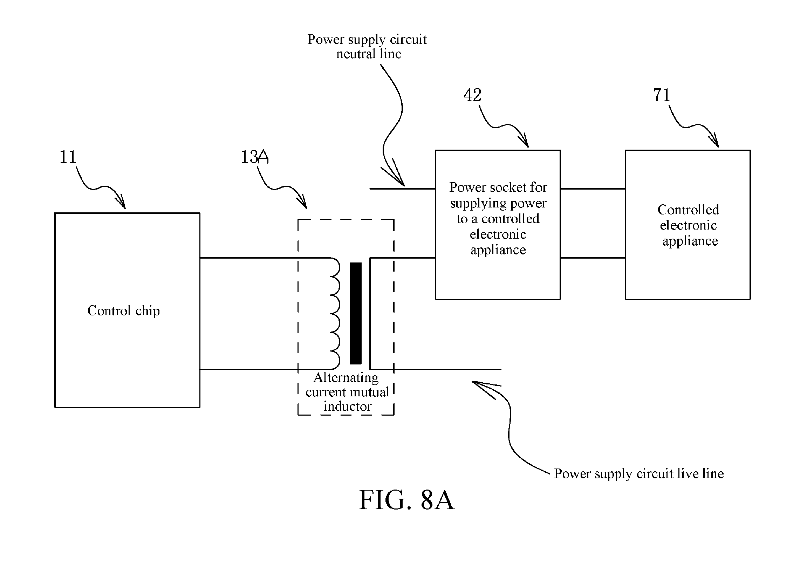

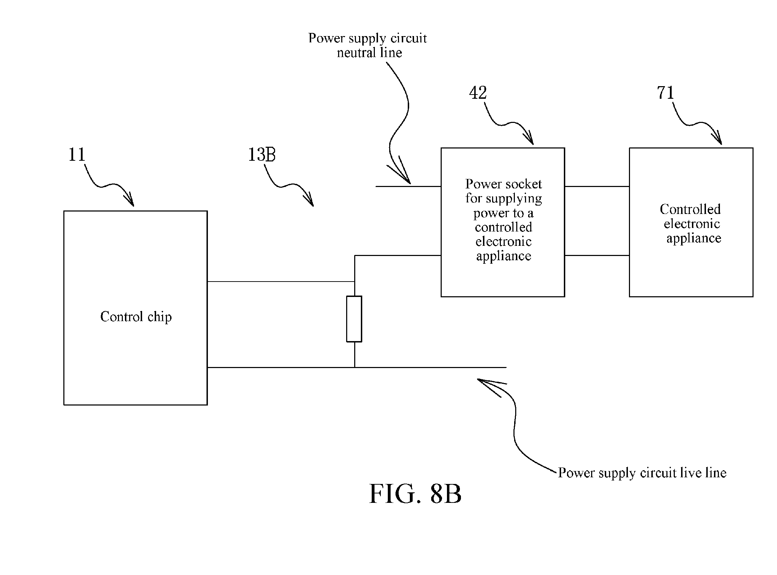

The control unit 10 includes a control chip 11, a memory 12, a controlled electronic appliance power consumption current sensor 13, a setting and manual switch button 14 and a setting and work status indicator lamp 15. The memory 12 is connected to the control chip 11 and is used for storing an infrared remote power-on/off signal of the controlled electronic appliance. A preheating time of the controlled electronic appliance after the power source is turned on and a type of the controlled electronic appliance being in a standby or power-on status upon turning on the power source are written and used by the control chip 11, and may be saved for a long time after power cutoff. The controlled electronic appliance power consumption current sensor 13 is connected to the control chip 11 and a live wire in the power socket for supplying power to a controlled electronic appliance 42 to detect a power consumption current value of the controlled electronic appliance and transfer the data to the control chip 11, which may be an alternating current mutual inductor 13A or a resistor 13B serially connected in a power supply circuit of the controlled electronic appliance (referring to FIG. 8A and FIG. 8B). The setting and manual switch button 14 is connected to the control chip 11 and is used for setting initial installation and perform manual switch. The setting and work status indicator lamp 15 is connected to the control chip 11. Light red is used for indicating an initial setting status. Light blue is used for indicating a preheating status of the controlled electronic appliance. The control chip 11, the memory 12, the controlled electronic appliance power consumption current sensor 13, the setting and manual switch button 14 and the setting and work status indicator lamp 15 may adopt conventional components.

The infrared remote control signal receiving unit 20 includes an infrared signal receiving diode 21 and an infrared signal amplification circuit 22. The infrared signal receiving diode 21 is connected to the infrared signal amplification circuit 22 and transfers the received infrared control signal to the infrared signal amplification circuit 22, which is a pure infrared signal receiver component and does not perform amplification, filtering and detection processing on the received infrared signal. The infrared signal amplification circuit 22 is connected to the infrared signal receiving diode 21 and the control chip 11 and amplifies the received infrared control signal and transfers the amplified signal to the control chip 11. The infrared signal amplification circuit 22 only amplifies the infrared signal and does not perform filtering and detection processing on the infrared signal. The signal transferred to the control chip 11 contains a carrier. As the infrared remote control signal has various carrier frequencies and carrier manners, for example, the carrier frequency range may be between 30 KHz and 56 KHz, the use of an integrated infrared signal receiver component containing amplification, filtering and detection processing functions or an amplification circuit containing filtering and detection processing functions filter carrier signals in the infrared signal, such that the received infrared signal cannot be copied and transmitted again. The infrared signal receiving diode 21 may adopt a conventional component. The infrared signal amplification circuit 22 may adopt a universal signal amplification circuit.

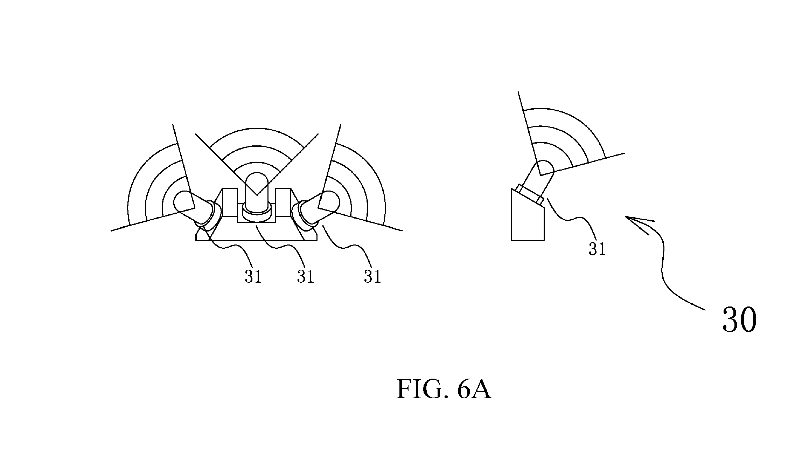

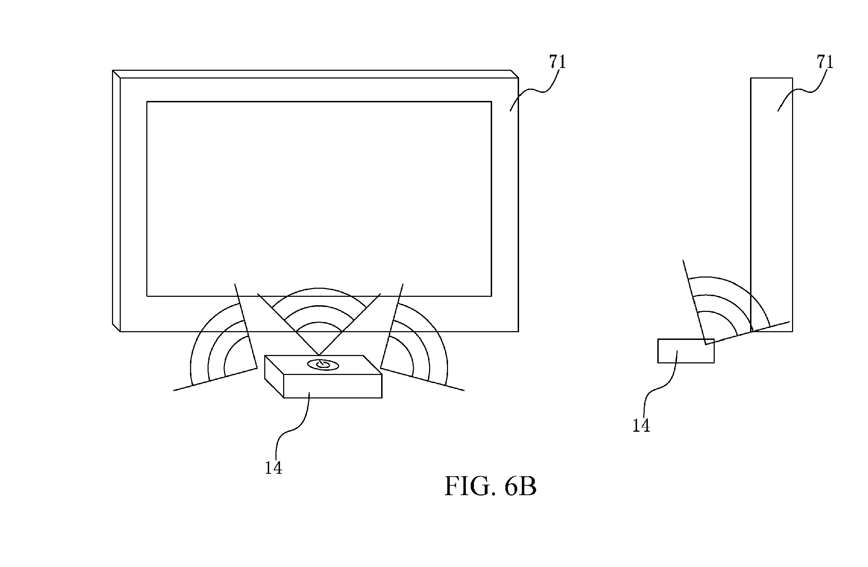

The infrared remote control signal transmitting unit 30 includes an infrared transmitter diode 31 or a number of infrared transmitter diodes 31 arranged at an angle between each other and is connected to the control chip 11. The infrared remote power-on/off signal sent from the control chip 11 is transmitted to the controlled electronic appliance 71. As the device control portion 61 is placed in front of the controlled electronic appliance 71 and is close to the controlled electronic appliance 71 while a signal transmission angle of the infrared transmitter diode 31 is limited, the front surface of the controlled electronic appliance 71 might be unable to be covered, and the controlled electronic appliance 71 might be unable to receive the infrared remote power-on/off signal. Therefore, a number of infrared transmitter diodes 31 arranged at an angle between each other may be adopted to cover the front surface of the controlled electronic appliance 71 (referring to FIG. 6A and FIG. 6B). The infrared transmitter diode 31 may adopt a conventional component.

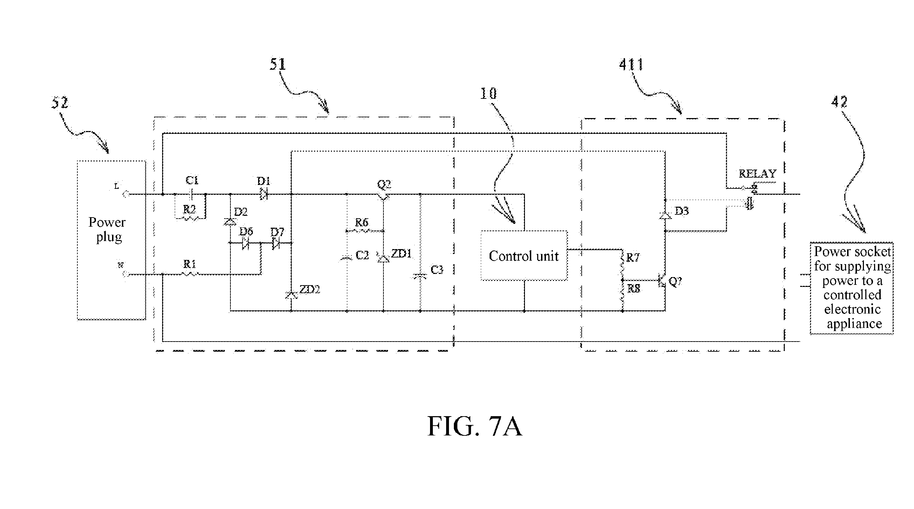

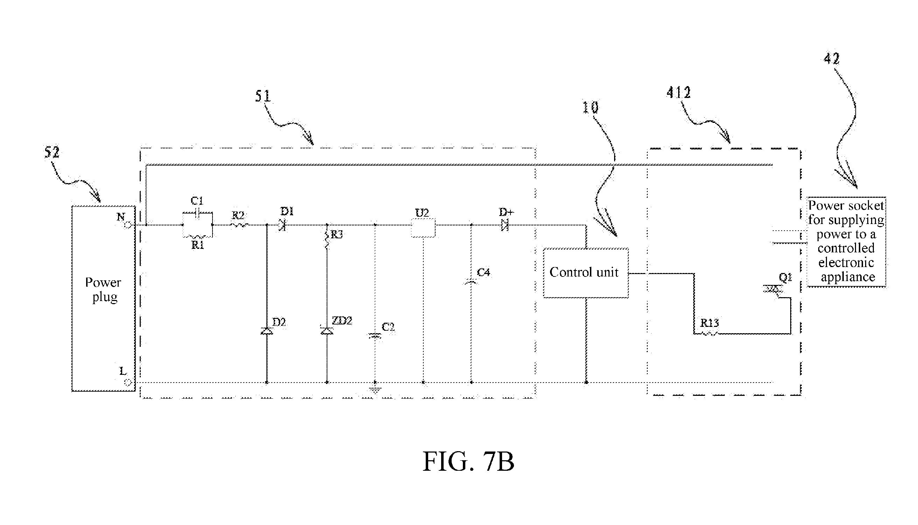

The controlled electronic appliance power supply switch unit 40 includes a controlled electronic appliance power supply switch 41 and a power socket for supplying power to a controlled electronic appliance 42. The controlled electronic appliance power supply switch 41 is connected to the control chip 11. The control chip controls to turn on or turned off the power supply to the controlled electronic appliance. The controlled electronic appliance power supply switch 41 is connected to the power supply unit 50 to acquire direct current power supply from the power supply unit 50 to drive the switch component relay 4111 or controlled silicon 4121. The controlled electronic appliance power supply switch 41 is connected to a power plug 52 connected to the external power source 72 and is connected to the power socket for supplying power to a controlled electronic appliance 42, so as to turn on or turned off the power supply of the controlled electronic appliance. The controlled electronic appliance power supply switch 41 may be a universal relay switch circuit 411 (referring to FIG. 7A) or a silicon controlled switch circuit 412 (referring to FIG. 7B), the component thereof may adopt a conventional component. The power socket for supplying power to a controlled electronic appliance 42 is connected to the controlled electronic appliance power supply switch 41 and is used for plugging a power input end (power plug) 73 of the controlled electronic appliance 71 to realize the power supply to the controlled electronic appliance, which is a standard power supply socket in an area where the device is used.

The power supply unit 50 includes a direct current power supply circuit 51 and a power plug 52 connected to the external power source 72. The direct current power supply circuit 51 is connected to the control unit 10 and the controlled electronic appliance power supply switch unit 40 and performs voltage drop, rectification, filtering and voltage stabilization processing on the external power source to provide direct current power supply to all units in the device, which may adopt a conventional direct current power supply circuit and a conventional component. The power plug 52 is connected to the power supply unit 50 and the controlled electronic appliance power supply switch unit 40 and is connected to an external power source through being plugged in the external power source socket 72, which is a standard power supply plug in an area where the device is used.

Although the present invention is disclosed through the above embodiments, the scope of the present invention is not limited thereto. The above means may be replaced by similar or equivalent elements well known to person skilled in the art without departing from the concept of the present invention.

## Claims

1. A device for eliminating standby power consumption of an electronic appliance having infrared remote control switch capability, comprising:
a control unit (10);
an infrared remote control signal receiving unit (20), connected to the control unit (10); and
an infrared remote control signal transmitting unit (30), connected to the control unit (10); and
a controlled electronic appliance power supply switch unit (40), connected to the control unit (10), a power supply unit (50) and a power input end of a controlled electronic appliance (71); and
the power supply unit (50) of the device, connected to the control unit (10) and the controlled electronic appliance power supply switch unit (40).

2. The device for eliminating standby power consumption of an electronic appliance having infrared remote control switch capability according to claim 1, wherein the control unit (10) comprises a control chip (11), a memory (12), a controlled electronic appliance power consumption current sensor (13), a setting and manual switch button (14) and a setting and work status indicator lamp (15); the memory (12), the controlled electronic appliance power consumption current sensor (13), the setting and manual switch button (14) and the setting and work status indicator lamp (15) are all connected to the control chip (11), the controlled electronic appliance power consumption current sensor (13) is further connected to the controlled electronic appliance power supply switch unit (40), the memory (12) is used for storing an infrared remote power-on/off signal of a controlled electronic appliance, a preheating time of the controlled electronic appliance upon turning on the power source and a type of the controlled electronic appliance being in a standby or power-on status upon turning on the power source are written and used by the control chip (11) and is saved for a long time after power cutoff.

3. The device for eliminating standby power consumption of an electronic appliance having infrared remote control switch capability according to claim 1, wherein the infrared remote control signal receiving unit (20) comprises an infrared signal receiving diode (21) and an infrared signal amplification circuit (22); the infrared signal receiving diode (21) is connected to the infrared signal amplification circuit (22), the infrared signal amplification circuit (22) is connected to the control chip (11) of the control unit (10); the infrared signal receiving diode (21) is a pure infrared signal receiver component and does not perform amplification, filtering and detection processing on the received infrared signal, the infrared signal amplification circuit (22) only amplifies the infrared signal and does not perform filtering and detection processing on the infrared signal, and the signal transferred to the control chip (11) contains a carrier.

4. The device for eliminating standby power consumption of an electronic appliance having infrared remote control switch capability according to claim 1, wherein the infrared remote control signal transmitting unit (30) comprises one or more infrared transmitter diodes (31), and the infrared transmitter diode (31) is connected to the control chip (11).

5. The device for eliminating standby power consumption of an electronic appliance having infrared remote control switch capability according to claim 1, wherein the controlled electronic appliance power supply switch unit (40) comprises a controlled electronic appliance power supply switch (41) and a power socket for supplying power to a controlled electronic appliance (42); the controlled electronic appliance power supply switch unit (40) is connected to the control unit (10) and the power supply unit (50), and is connected to a power input end (73) of the controlled electronic appliance (71) through the power socket for supplying power to a controlled electronic appliance (42) connected thereto.

6. The device for eliminating standby power consumption of an electronic appliance having infrared remote control switch capability according to claim 1, wherein the power supply unit (50) performs voltage drop, rectification, filtering, voltage stabilization processing on the external power source to provide direct current power supply to all units in the device; the power supply unit (50) comprised a direct current power supply circuit (51) and a power plug (52) connected to an external power source (72); the power supply unit (50) is connected to the control unit (10) and the controlled electronic appliance power supply switch unit (40) and is connected to the external power source through the power plug (52) connected thereto.

7. The device for eliminating standby power consumption of an electronic appliance having infrared remote control switch capability according to claim 1, wherein the power supply unit (50) is connected to an external power source (72) in coordination.

8. The device for eliminating standby power consumption of an electronic appliance having infrared remote control switch capability according to claim 1, wherein the controlled electronic appliance power consumption current sensor (13) used for detecting a power consumption current of the controlled electronic appliance is an alternating current mutual inductor (13A) or a resistor (13B) serially connected in a power supply circuit of the controlled electronic appliance.

9. The device for eliminating standby power consumption of an electronic appliance having infrared remote control switch capability according to claim 4, wherein when a number of the infrared transmitter diodes (31) exist, the infrared transmitter diodes (31) are arranged at an angle between each other.

10. The device for eliminating standby power consumption of an electronic appliance having infrared remote control switch capability according to claim 5, wherein the controlled electronic appliance power supply switch (41) is a relay switch circuit (411) or a silicon controlled switch circuit (412) controlled by the control unit (10).
